# EUROPEAN PATENT SPECIFICATION

(11) **EP 3 428 326 B1**
(45) Date of publication and mention of the grant of the patent: **29.04.2020**
(21) Application number: 17763290.8
(22) Date of filing: 08.03.2017
(51) Int. Cl.: C30B 33/06, C30B 29/20, C30B 29/12, G01N 21/05, G01N 15/14

(54) **METHOD FOR JOINING CRYSTAL BODY**
VERFAHREN ZUR VERBINDUNG VON KRISTALLKÖRPERN
PROCÉDÉ D'ASSEMBLAGE D'UN CORPS CRISTALLIN

(30) Priority: 08.03.2016 JP 2016043989; 16.02.2017 JP 2017026513
(43) Date of publication of application: 16.01.2019
(73) Proprietor: Japan Cell Co., Ltd., Machida-shi, Tokyo 194-0215 (JP)
(72) Inventor: FUKAZAWA Atsushi, Machida-shi Tokyo 194-0215 (JP); HAYATA Satoshi, Machida-shi Tokyo 194-0215 (JP); SATO Kazuyuki, Machida-shi Tokyo 194-0215 (JP); OMURA Kiminori, Machida-shi Tokyo 194-0215 (JP); KASAI Hiromu, Machida-shi Tokyo 194-0215 (JP)
(74) Representative: Dehns
(86) International application number: PCT/JP2017/009149
(87) International publication number: WO 2017/154950

(56) References cited:
- WO-A1-2015/098927
- JP-B2- 3 499 717
- JP-B2- 4 224 336
- JP-B2- 4 251 462
- JP-B2- 4 251 462

## Description

### [Field of the Invention]

The present invention relates to a bonding method for a crystal body such as synthetic corundum (Al₂O₃), used as the material of a flow-cell which is incorporated in a fine particle counter measuring fine particles included in liquids such as hydrogen fluoride, or calcium fluoride (CaF₂) and magnesium fluoride (MgF₂) which are used as an optical component.

### [Background Art]

Conventionally, a plurality of plate-shaped synthetic corundum pieces are prepared and these synthetic corundum pieces are bonded to manufacture a flow cell made of synthetic corundum.

When bonding these pieces by using an adhesive material, a boundary surface comes into existence at the bonding surface and then light refraction or light reflection can occur. Additionally, when bonding these pieces by thermal fusion, air bubbles can be confined in the bonding surface.

The present applicant has proposed Patent Documents 1-3.

The bonding methods disclosed in the above Patent Documents 1-3 are basically the same, that is: firstly, cut off synthetic corundum pieces from a crystal block, polish the surface of each synthetic corundum piece, then overlap each polished surface and strongly press (pinch) the one end side of the two facing pieces of the synthetic corundum.

The press strength is such that interference fringes are observed between the surfaces of the synthetic corundum pieces, and in this state the two pieces of synthetic corundum are heated at melting point (2030 degrees Celsius) or less, thereby gradually forming a fusion bonding state from one end of the synthetic corundum piece to the other end.

In the above, once an optical contacting state or a chemical pressurized fusion bonding state is achieved at one end side of the strongly pressed configuration, and the interference fringe disappears by heating, it is considered that the optical contacting state or the chemical pressurized fusion bonding state continues to the other end side.

Thus, an optical boundary surface does not exist in the synthetic corundum body bonded together in this manner and an extremely superior three-dimensional structure is provided.

### [Prior Art]

### [Patent Document]

[Patent Document 1] JP. PAT. No. 3499717
[Patent Document 2] JP. PAT. No. 4224336
[Patent Document 3] JP. PAT. No. 4251462

### [Disclosure of Invention]

### [Problems Solved by the Invention]

The bonding structure which is manufactured by the method disclosed in Patent Documents 1-3 is superior in chemical resistance and there is no malfunction such as the bonding surface peeling off, or refraction or reflecting back at the adhesion surface,

On the other hand, there is a problem that the yield rate is insufficient.

In the conventional method, a gap is generated as interference fringes are caused to form between the bonding surfaces, but by pressing one end side more strongly than the other end side, the other end side may not bond at all.

Thus, the gap formed between the bonding surfaces of the synthetic corundum pieces at the other end side is not constant.

This is regarded as the reason that the yield rate is insufficient.

The same problem occurs when crystal bodies such as calcium fluoride (CaF₂) and magnesium fluoride (MgF₂) are bonded together.

### [Means for Solving Problems]

To solve the above described problem, a bonding method for the crystal body piece of the present invention is as follows:
Put the surfaces of the pieces of the crystal body which will be bonded together to face each other, strongly press the one end side of the two crystal body pieces whilst overlapped, generate an interference fringe on the overlapped surfaces, dissipate the interference fringe on the overlapped surfaces by heating the crystal body pieces at a temperature less than melting point of the crystal body in this state, wherein a fine spacer is inserted between the other end side of the crystal body pieces bonded together with each other, the fine spacer consisting of material which can be crushed flat by the pressure force at the time of the heating, and wherein the crystal body pieces are synthetic corundum, calcium fluoride or magnesium fluoride.

As for the spacer, it should not interfere with the dissipation of the interference fringe by the heat-treatment.

That is, for the spacer, it is necessary to have crush characteristics (elasticity, softness), such that the spacer does not interfere with the optical contact or chemical pressurized fusion bonding state.

An example of the spacer is cotton fiber, but it is not limited to this.

The diameter of the spacer depends on the bonding length of the synthetic corundum piece, but 15-60µm is preferable to generate interference fringes.

Also, in the bonding method of the present invention, with a temporary bonding state pressing the one end of the crystal body pieces to be bonded, it can be judged before heat-treatment whether the temporary bonding state is acceptable or not by the number of interference fringes per unit of crystal body piece length.

Also, the pressed part of the one end of the crystal body piece can be all or part of the widthwise direction.

### [Effects of the Invention]

According to the present invention, when bonding crystal body pieces together by heat-treatment in the state where one end side is pressed more strongly than the other end side without the use of an adhesive material, the gap between the crystal body pieces at the other end side can be precisely controlled by a spacer; thus, it can improve yield rate.

Also, with regard to the state of the temporary bonding before heat- treatment, whether the temporary bonding is good or bad can be judged by counting the number per unit length of an interference fringe formed on the bonding surfaces of a crystal body piece which will be bonded together.

Also, when pressure is applied by the jig in the widthwise direction, only a part of the widthwise piece is marked by the jig stick /arm, limiting the incompatible portion after bonding and thereby saving on waste materials.

### [Brief Description of the Drawings]

[Fig1] Side view of two overlapped synthetic corundum pieces.
[Fig2] Top view of one piece of synthetic corundum having a spacer on the end.
[Fig3] Photograph of the interference fringe generated when two synthetic corundum pieces are put on top of one another.
[Fig4] (a) Photograph of two synthetic corundum pieces before bonding, (b) Photograph after bonding.
[Fig5] (a) Front photograph of the structure when three magnesium fluoride crystal bodies are bonded simultaneously, (b) Rear photograph of the structure.
[Fig6] Figure illustrating an alternative embodiment.

### [Best Mode For Carrying Out the Invention]

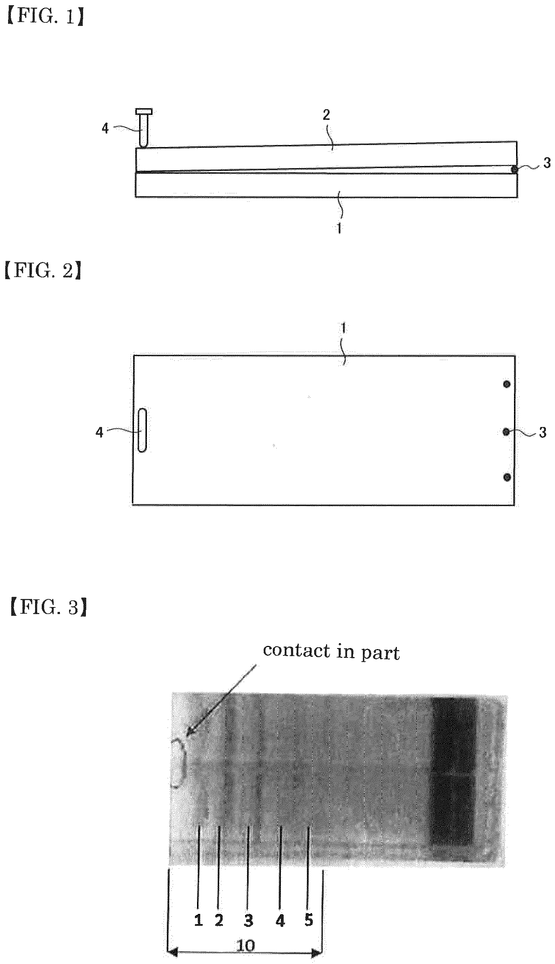

Embodiments of the present invention will be described below with reference to the accompanying drawings. In the examples shown in Figs 1 to 4, synthetic corundum is used as a crystal body.

Fig 1 is a side view in a state where two composite corundum pieces are superimposed, and Fig 2 is a top view of one piece of synthetic corundum having a spacer on the end. In accordance with the embodiment, firstly prepare two synthetic corundum pieces 1, 2.

These synthetic corundum pieces 1, 2 are cut from a crystal block, the pieces are washed subsequently after having the surfaces which will be bonded together polished, and it is confirmed that there is no contamination or particles on the bonding surface. In the illustrated example, two synthetic corundum pieces are overlapped, but three or more synthetic corundum pieces can be stacked and joined at the same time.

It is not necessary to completely synchronize a crystal axis, edge and axial angle when overlapping the synthetic corundum pieces 1, 2.

It is preferable to assume a displacement of less than 5 degrees of axis, edge and axial angle of the corundum pieces 1, 2.

The one end of synthetic corundum pieces 1,2 is pressed or clamped strongly by jig 4. It is possible to press the whole area of the widthwise direction by jig 4, however in the illustration example, it is pressed or clamped only at the center of the widthwise direction, thereby reducing incompatible portion after the bonding.

On the other end side of synthetic corundum piece 1, 2, spacer 3 intervenes between the surfaces which will be bonded.

Although the spacer 3 is shown larger in scale for clarity in the figure, cotton fiber having a diameter of 30 µm is used in the embodiment.

Spacer 3 is crushed flat by the pressure force which effects the other end side of synthetic corundum pieces 1, 2 in the case of heat-treatment after the temporary bonding. Thereby, spacer 3 does not disturb the synthetic optical contacting or chemical pressurized fusion bonding state of corundum pieces 1, 2.

As for spacer 3, gel beads can also be applied.

Material generating large quantities of gas in the case of heat-treatment after the temporary bonding is not suitable, because an air bubble may remain on the bonding surface.

Fig 3 is a photograph of two synthetic corundum pieces overlapped and pressed on one end side. As is clear from this photograph, interference fringes are observed to come from the fine gap between surfaces which will be bonded .

The interval of the above described interference fringe is proportional to the size of the fine gap of the bonding surface; therefore, by counting the number of the interference fringes per unit length in the temporary bonding state, it is possible to judge beforehand whether the fine gap of the bonding surface of the synthetic corundum pieces 1,2 is in the proper range or not. In this embodiment, five stripes are observed in a unit length.

The above-mentioned temporarily bonded synthetic corundum piece is heated to a temperature less than the melting point of the corundum and maintained for a predetermined time.

Then, the optical contact or the chemically pressed and adhered state progresses from the one end side, which is already in the optical contact or chemically compression bonded state, to the other end side, and in accordance with this progression, the gas existing between the synthetic corundum pieces is completely removed between the synthetic corundum pieces, and the entire bonding surface is brought into an optical contact or chemically compression bonded state.

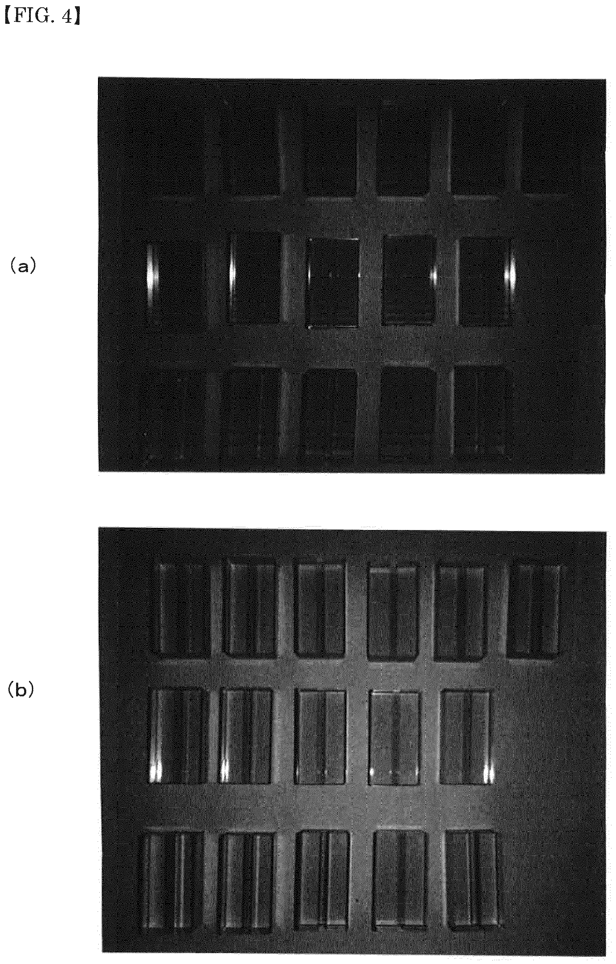

Fig 4(a) is a photograph of two synthetic corundum pieces before bonding, (b) is a photograph after bonding, and in FIG. 4(a), 16 pairs of synthetic corundum pieces overlapped in vertical direction are observed.

In each pair, a flow channel to allow a fluid to pass through is formed in the center portion. The right and left portions of the passage are bonded to each other, and an interference fringe is observed before heat-treatment.

Further, in photograph (b) showing after heat-treatment, the above described interference fringes were not observed at all, and no optical boundary surface was observed, in all of the specimens.

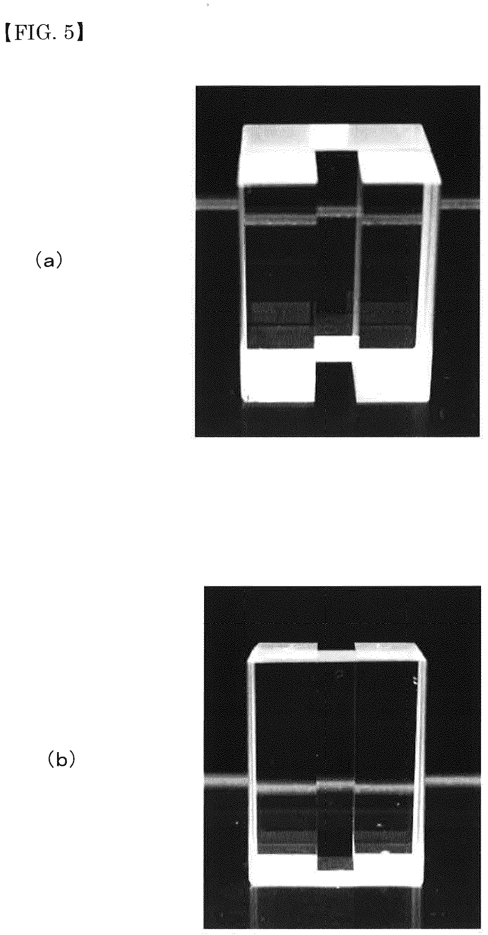

Fig 5(a) is a front photograph of the structure obtained by bonding three magnesium fluoride crystal bodies simultaneously, and (b) is a rear photograph of the structure after the bonding. It is notable that the above described interference fringes are not observed at all, and no optical boundary surface is observed in these photographs.

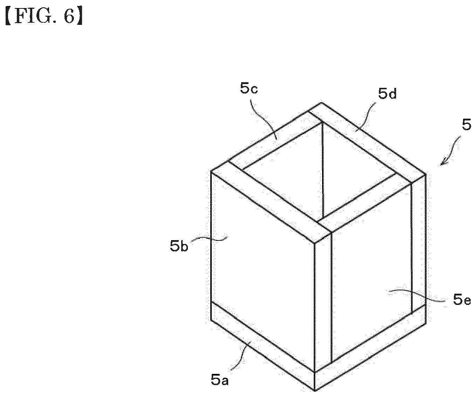

FIG. 6 indicates a three-dimensional structure prepared by the method of the present invention.

The three-dimensional structure 5 consists of base plate 5a and four side-plates 5b, 5c, 5d, and 5e comprising synthetic corundum, the side-plates being bonded along the sides of base plate 5a.

The three-dimensional structure 5 is manufactured by one heat-treatment by applying the method of the present invention to the facing portion between base plate 5a and the side-plates 5b, 5c, 5d, 5e, and the facing portions between each side-plate.

Also, the method of the present invention can be applied to the bonding of a crystal body such as calcium fluoride as well as synthetic corundum or magnesium fluoride.

Further, while the example in which the synthetic corundum pieces and the magnesium fluoride crystal pieces are joined to each other has been shown in the embodiment, the method of the present invention can be applied to the case where the synthetic corundum piece and the magnesium fluoride crystal piece, the synthetic corundum piece and the calcium fluoride crystal, or the magnesium fluoride crystal pieces and calcium fluoride crystal pieces are joined.

### [Industrial Applicability]

The method of the present invention can apply not only to a flow cell installed in a particle counter but also to a lens, various optical components such as prisms, a machine part which requires hardness, and a vacuum chamber where a bonding surface is hermetically sealed.

As for the vacuum chamber, a gas enclosure glass cell and a high vacuum glass chamber are exemplified, which are used for calibration of a variable wavelength laser, calibration of a light spectrum analyzer, calibration of a gas analyzer, calibration of a wavelength meter, frequency standard, stable frequency source, laser cooling of atoms in magneto optical trap method.

### [Explanation of Letters or Numerals]

- 1, 2...: synthetic corundum pieces
- 3...: spacer
- 4...: press jig
- 5...: three-dimensional structure

## Claims

1. A bonding method for crystal body pieces, wherein the crystal body pieces are synthetic corundum, calcium fluoride or magnesium fluoride, **characterized by** aligning the surfaces of the pieces of the crystal body which will be bonded together, strongly pressing the one end side of the aligned crystal body pieces to generate an interference fringe between the surfaces put together, dissipating the interference fringe between the surfaces put together by heating the crystal body pieces at a temperature less than the melting point of the crystal body in this state, wherein a fine spacer is inserted between the other end side of the crystal body pieces bonded together, the fine spacer consisting of material which can be crushed flat by the pressure force at the time of heating.

2. A bonding method of the crystal body piece according to claim 1, **characterized in that** the diameter of the spacer is 15-60µm of fiber.

3. A bonding method of the crystal body piece according to claim 1, **characterized in that** the pressing part is only a portion of the widthwise direction of the crystal body piece.

## Patentansprüche

1. Verfahren zur Verbindung von Kristallkörperstücken, wobei die Kristallkörperstücke synthetisches Korund, Calciumfluorid oder Magnesiumfluorid sind, **gekennzeichnet durch** Ausfluchten der Oberflächen der Stücke des Kristallkörpers, die miteinander verbunden werden, starkes Pressen der einen Endseite der ausgefluchteten Kristallkörperstücke, um einen Interferenzstreifen zwischen den zusammengesetzten Oberflächen zu erzeugen, Auflösen des Interferenzstreifens zwischen den zusammengesetzten Oberflächen durch Erhitzen der Kristallkörperstücke auf eine Temperatur von weniger als dem Schmelzpunkt des Kristallkörpers in diesem Zustand, wobei ein dünner Abstandhalter zwischen der anderen Endseite der Kristallkörperstücke, die miteinander verbunden sind, eingeführt wird, wobei der dünne Abstandhalter aus Material besteht, das durch die Presskraft zum Zeitpunkt des Erhitzens flachgedrückt werden kann.

2. Verfahren zur Verbindung des Kristallkörperstücks nach Anspruch 1, **dadurch gekennzeichnet, dass** der Durchmesser des Abstandhalters 15-60 µm Faser ist.

3. Verfahren zur Verbindung des Kristallkörperstücks nach Anspruch 1, **dadurch gekennzeichnet, dass** der Pressteil nur ein Abschnitt der Breitenrichtung des Kristallkörperstücks ist.

## Revendications

1. Procédé de liaison pour des pièces de corps cristallin, dans lequel les pièces de corps cristallin sont du corindon synthétique, du fluorure de calcium ou du fluorure de magnésium, **caractérisé par** l'alignement des surfaces des pièces du corps cristallin qui seront liés ensemble, en pressant fortement le côté d'extrémité des pièces du corps cristallin alignées pour générer une frange d'interférence entre les surfaces assemblées, dissipant la frange d'interférence entre les surfaces assemblées en chauffant les pièces de corps cristallin à une température inférieure au point de fusion du corps cristallin dans cet état, dans lequel un espaceur fin est inséré entre l'autre côté d'extrémité des pièces de corps cristallin liées ensemble, l'espaceur fin étant constitué d'un matériau qui peut être écrasé par la force de pression au moment du chauffage.

2. Procédé de liaison de la pièce de corps cristallin selon la revendication 1, **caractérisé en ce que** le diamètre de l'espaceur est de 15 à 60 µm de fibre.

3. Procédé de liaison de la pièce de corps cristallin selon la revendication 1, **caractérisé en ce que** la partie de pression est uniquement une portion du sens de la largeur de la pièce de corps cristallin.
